# EUROPÄISCHE PATENTSCHRIFT

(11) **EP 1 647 051 B1**
(45) Veröffentlichungstag und Bekanntmachung des Hinweises auf die Patenterteilung: **06.10.2010**
(21) Anmeldenummer: 04734225.8
(22) Anmeldetag: 21.05.2004
(51) Int. Cl.: H05K 3/40, H01L 23/498, H01L 25/16, H05K 1/11, H05K 1/03

(54) **LEISTUNGSHALBLEITERMODUL MIT VOM SUBSTRAT GELÖSTEN LEITERBAHNENDEN ALS EXTERNE ANSCHLÜSSE**
SEMICONDUCTOR POWER MODULE WITH STRIP CONDUCTORS WHICH ARE DETACHED FROM A SUBSTRATE AS EXTERNAL CONNECTIONS
MODULE A SEMI-CONDUCTEUR DE PUISSANCE COMPORTANT DES PISTES CONDUCTRICES DETACHEES DU SUBSTRAT UTILISEES COMME CONNEXIONS EXTERNES

(30) Priorität: 11.07.2003 DE 10331574
(43) Veröffentlichungstag der Anmeldung: 19.04.2006
(73) Patentinhaber: eupec Europäische Gesellschaft für Leistungshalbleiter mbH, 59581 Warstein (DE)
(72) Erfinder: PASSE, Thomas, 58339 Epscheid (DE); FERBER, Gottfried, 59581 Warstein (DE); SPECHT, Benedikt, 59846 Sudern (DE)
(74) Vertreter: Schmuckermaier, Bernhard
(86) Internationale Anmeldenummer: PCT/EP2004/005450
(87) Internationale Veröffentlichungsnummer: WO 2005/008765

(56) Entgegenhaltungen:
- WO-A-00/55917
- DE-A1- 3 932 017
- DE-A1- 10 225 153
- DE-A1- 19 614 501
- GB-A- 775 267
- US-A- 4 924 292
- US-A- 5 559 374
- PATENT ABSTRACTS OF JAPAN Bd. 2003, Nr. 08, 6. August 2003 (2003-08-06) & JP 2003 124400 A (FUJI ELECTRIC CO LTD), 25. April 2003 (2003-04-25)

## Beschreibung

Die Erfindung liegt auf dem Gebiet der externen elektrischen Anschlusstechnik von Leistungshalbleitermodulen und betrifft ein Leistungshalbleitermodul mit einem Substrat, auf dem durch Strukturierung einer elektrisch leitenden, auf einer Substratseite aufgebrachten Beschichtung Leiterbahnen ausgebildet sind.

Bei in bekannter Weise (z. B. DE 101 42 971 A1) aufgebauten Leistungshalbleitermodulen ist auf der Oberseite eines Substrats mindestens ein Halbleiterbauelement (z.B. IGBT) angeordnet, das mit Leiterbahnen auf der Substratoberseite kontaktiert ist. Die metallisierte (z.B. kupferkaschierte) Substratunterseite ist zur Wärmeabfuhr auf ein Kühlelement andrückbar. Das Substrat ist von einem (Kunststoff-) Modulgehäuse umgeben und z.B. mittels Schraubverbindungen auf den Kühlkörper gepresst.

Zur Erzeugung der Leiterbahnen wird eine zunächst auf die Substratoberseite aufgebrachte Metallisierung durch an sich bekannte Verfahren (z.B. Ätzverfahren) strukturiert. An vorgegebenen Punkten und/oder an den Leiterbahnenden sind Kontaktstifte zum externen Anschluss des Moduls mit den Leiterbahnen elektrisch verbunden, z.B. verlötet.

Diese Konstruktion ist fertigungstechnisch aufwendig. Außerdem sind je nach gewünschter Kontaktierungstechnologie - z.B. Oberflächenkontaktierung (nachfolgend auch als SMT Surface-Mounting-Technologie bezeichnet) oder Kontaktierung über Anschlusskontaktstifte - unterschiedliche Basissubstrate erforderlich.

In dem herkömmlichen integrierten Schaltkreis der US 5,559,374 werden beispielsweise Anschlusswinkel 4, 5, 6 auf eine strukturierte Metallfolie 3 gelötet, die externe Anschlüsse 4A, 5A, 6A aufweisen.

An den Substratkanten des in der DE 196 14 501 A1 beschriebenen Keramik-Metall-Substrates 1 sind zur Kontaktierung von der Oberseite 8, 8' und Unterseite 9 des Substrates 1 Teile der aufgebrachten Metallschicht 7, 7' in U-Form umgebogen, wobei die gebogenen Metallschichtenden, verbunden über abgeteilte Bereiche 2" einer Keramikschicht 2a, plan an der Unterseite des Substrates 1 anliegen. Hierdurch ergibt sich ein freistehendes, beidseitig kontaktierbares metallbeschichtetes Substrat 1, das allerdings keine nach außen führenden externen Anschlüsse aufweist.

In dem Leistungshalbleiterbauelement der WO 00/55917 ist die Metallisierung 8 auf der Oberseite 5 der Keramiksubstrate 4 senkrecht zu einer Greiflasche 10 nach oben gebogen. Die Laschen 10 führen jedoch nicht direkt nach außen, sondern werden an ein nach außen führendes Anschlusselement (7) gelötet oder geschweißt.

Nach der in der DE 39 32 017 A1 dargestellten Methode werden auf einer Leiterplatte sowohl Leiterbahnen als auch Anschluss- und Steckerbereiche in einem Arbeitsgang metallisiert. Die Metallstrukturen werden in den Anschlussbereichen abgelöst, sodass integrierte freistehende Anschluss- und Steckerbereiche entstehen. Offen bleibt die Führung dieser Anschluss- und Steckerbereiche nach außen und die zerstörungsfreie Kontaktierung außerhalb eines die Leiterplatte umgebenden Gehäuses.

Aufgabe der vorliegenden Erfindung ist daher die Bereitstellung eines kostengünstig und einfach herstellbaren Leistungshalbleitermoduls, das unter Verwendung eines einheitlichen Basissubstrats verschiedene Montagetechniken ermöglicht.

Diese Aufgabe wird durch ein Leistungshalbleitermodul gemäß Patentanspruch 1 gelöst. Ausgestaltungen und Weiterbildungen des Erfindungsgedankens sind Gegenstand von Unteransprüchen.

Insbesondere wird die Aufgabe dadurch gelöst, dass die Leiterbahnen als integrale Leiterbahnbestandteile freie, von der Substratseite gelöste Leiterbahnenden aufweisen, die sich als externe Anschlüsse von dem Substrat wegerstrecken.

Ein wesentlicher Aspekt der Erfindung ist die direkte durchgehende und einstückige Verbindung der integralen Anschlusselemente zum-externen elektrischen Anschluss mit den Leiterbahnen. Dadurch entfallen andernfalls erforderliche (interne) Verbindungen zwischen Leiterbahn und separatem Anschlusselement, z.B. einem Kontaktstift. Damit ist ein in seinen elektrischen Eigenschaften verbessertes, nämlich niederinduktives, niederohmiges, Leistungshalbleitermodul geschaffen. Außerdem ist die Bauhöhe des Leistungshalbleitermoduls vermindert.

Vorteilhafterweise können die Anschlusselemente vergleichsweise eng angeordnet werden und erlauben so eine hohe Packungsdichte erfindungsgemäßer Leistungshalbleitermodule.

Zudem ist durch die verminderte Anzahl von zu handhabenden und zu montierenden Bauteilen die Herstellung erheblich vereinfacht und durch den Wegfall zusätzlicher (interner) elektrischer Verbindungen die Gefahr von fehlerhaften Verbindungen vermindert und damit die Ausbeute und Zuverlässigkeit des erfindungsgemäßen Leistungshalbleitermoduls erhöht.

Ein weiterer wesentlicher Aspekt der Erfindung besteht darin, dass die Leiterbahnenden, dadurch dass sie frei und von der Substratoberseite gelöst sind, in variablem Winkel von der Substratoberseite weggebogen werden können und damit eine flexible Gestaltung erlauben. Insbesondere können je nach schaltungstechnischen Erfordernissen in Anzahl, Form und Art - z.B. sowohl als Steuer- als auch als Lastanschlüsse ausgebildete - angepasste Anschlusselemente vorgesehen werden. Die Anschlusselemente können je nach erforderlicher Stromtragfähigkeit konfiguriert sein.

Bei der Erfindung ist das Substrat in an sich bekannter Weise von einem Gehäuse bedeckt oder umgeben, wobei sich die freien Leiterbahnenden vorteilhafterweise durch das Gehäuse hindurch nach außen erstrecken. Das Gehäuse fungiert in Doppelfunktion nicht nur zum Schutz der Bauelemente und des Substrats, sondern kann die Leiterbahnenden mechanisch abstützen, führen und schützen.

Die aus dem Gehäuse austretenden Leiterbahnenden können dann je nach gewünschtem Anschlussverfahren - z.B. in für die SMT-Montage geeigneter Form - umgebogen und auf eine Montageseite des Gehäuses gebogen werden. Sie können aber auch zu Einsteckelementen mit gewünschter, z.B. stift- oder laschenförmiger Gestalt geformt werden.

Die Erfindung wird nachfolgend anhand der in den Figuren der Zeichnung dargestellten Ausführungsbeispiele näher erläutert, wobei für gleiche Elemente dieselben Bezugszeichen verwendet werden. Es zeigen:
- Figur 1: in perspektivischer Ansicht ein Ausfüh- rungsbeispiel eines Leistungshalbleitermoduls,
- Figuren 2 und 3: Querschnittansichten eines erfindungsgemäßen Ausführungsbei- spiels nach Figur 1 mit einem Gehäuse,
- Figuren 4 bis 6: Varianten eines erfindungsgemäßen Leis- tungshalbleitermoduls und
- Figuren 7 und 8: Montagemöglichkeiten eines erfindungsge- mäßen Leistungshalbleitermoduls.

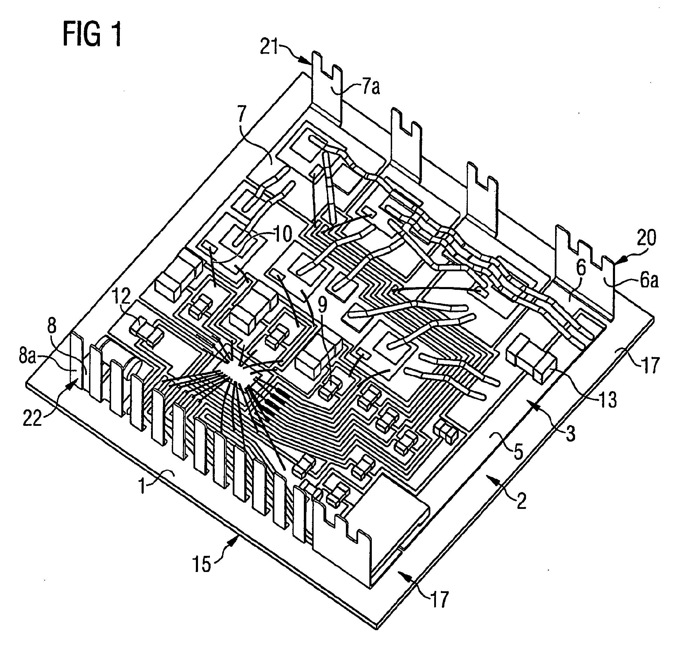

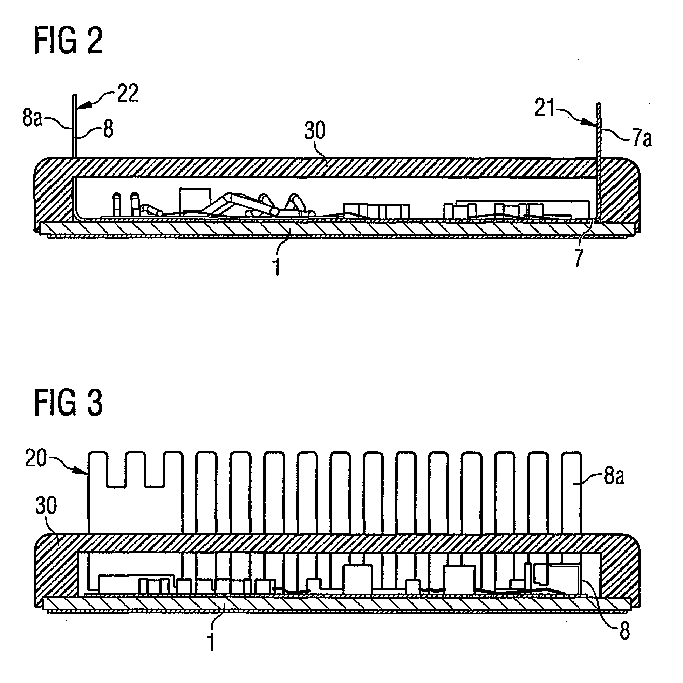

Figur 1 zeigt ein Substrat 1, auf dessen Substratoberseite 2 eine beispielsweise aus Kupfer bestehende Oberseitenmetallisierung 3 aufgebracht ist. Aus dieser Metallisierung ist durch ein an sich bekanntes Strukturierungsverfahren eine Struktur von Leiterbahnen (z.B. 5, 6, 7, 8) und Anschlusskontaktflächen (z.B. 9) erzeugt. Mit diesen sind durch Lötung oder Bonddrähte 10 Halbleiterbauelemente 12, 13 mechanisch bzw. elektrisch verbunden. Bei den Halbleiterbauelementen kann es sich um IGBTs und/oder Dioden handeln. Das Substrat 1 kann aus Keramik bestehen und an seiner Unterseite 15 (s.a. Figur 2) ebenfalls metallisiert sein.

Das Substrat bildet ein Basissubstrat für ein anschlussmäßig verschieden konfigurierbares Leistungshalbleitermodul. Dazu sind in zur äußeren Kontaktierung vorgesehenen Bereichen, bevorzugt im Randbereich 17 des Substrats 1, einige der Leiterbahnen 6, 7, 8 von der Substratoberseite 2 gelöst und mit ihren dadurch freien Leiterbahnenden 6a, 7a, 8a rechtwinklig von der Substratoberseite weggebogen. Die Leiterbahnenden bilden in nachfolgend noch detaillierter Weise integrale äußere Anschlusselemente 20, 21, 22 der Leiterbahnen zur externen Kontaktierung (z.B. als Steuer- oder Lastanschlüsse). Ein wesentlicher Aspekt ist dabei die materialdurchgängige einstückige Verbindung der Leiterbahnen 6, 7, 8 mit dem jeweiligen Anschlusselement 20, 21, 22. Die Position und Orientierung der Anschlusselemente können je nach Bedarf verändert werden. Die Anschlusselemente können z.B. als Schraublaschen, Schweißkontakte, Lötkontakte oder zur SMT-Montage ausgebildete Kontakte realisiert sein.

Durch diese Ausgestaltung ist die Herstellung wesentlich vereinfacht, die Zuverlässigkeit wegen des Entfalls zusätzlicher Verbindungsstellen zwischen Leiterbahnen und Anschlusselemente erheblich erhöht, bei sehr niederohmigem und niederinduktivem Verhalten eine niedrige Bauhöhe realisiert und eine hohe Packungsdichte des erfindungsgemäßen Leistungshalbleitermoduls ermöglicht.

Die Figuren 2 und 3 verdeutlichen in Querschnittsdarstellung des von einem (Duroplast-)Gehäuse 30 umgebenden Substrats 1 gemäß Figur 1 die vorteilhafte abstützende Funktion des Gehäuses auf die durchgeführten Leiterbahnenden 7a, 8a bzw. 6a und damit auf die Anschlusselemente 20, 21, 22. Die Anschlusselemente sind dadurch für einen direkten Anschluss mechanisch ausreichend stabilisiert und können je nach gewünschter Kontaktierungstechnologie in einem variablen Winkel endgeformt werden.

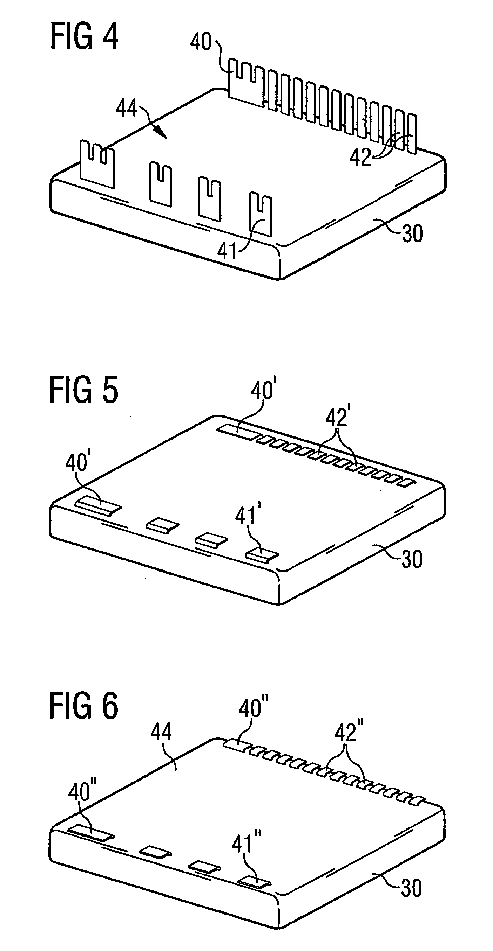

Ausgehend von dem Herstellungszustand nach den Figuren 2 und 3 zeigen die Figuren 4 bis 6 Varianten hinsichtlich der endgültigen Ausformung der Leiterbahnenden.

Figur 4 zeigt im wesentlichen die Ausgestaltung, die auch schon in den Figuren 2 und 3 unmittelbar erkennbar ist. Hier durchdringen zu mehrfach 40, doppelt 41 oder einfach 42 steckbaren oder durchsteckbaren Anschlusskontakten ausgeformte Leiterbahnenden die Montageseite 44 des Gehäuses 30. Dieses Leistungshalbleitermodul ist somit als "Steckmodul" ausgestaltet.

Figur 5 zeigt eine Variante, bei der durch Umbiegen der Leiterbahnenden 40', 41', 42' nach innen auf die Montageseite 44 des Gehäuses 30 ein SMT-fähiges Leistungshalbleitermodul geschaffen ist.

Figur 6 zeigt eine Variante, bei der durch Umbiegen der Leiterbahnenden 40", 41", 42" nach außen auf die Montageseite 44 des Gehäuses 30 ein SMT-fähiges Leistungshalbleitermodul geschaffen ist.

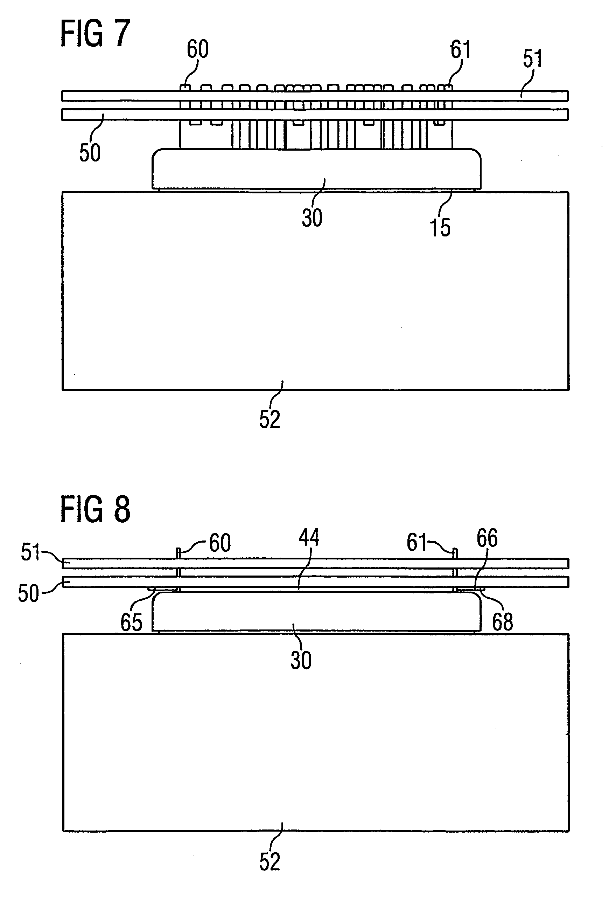

Die Figuren 7 und 8 zeigen Seitenansichten eines auf eine Leiterplatte (PCB) 50 montierten und außerdem mit einem Leiter (Busbar) 51 elektrisch verbundenen erfindungsgemäßen Leistungshalbleitermoduls. Das Leistungshalbleitermodul ist mit der Modul- bzw. Substratunterseite 15 auf einem Kühlkörper 52 montiert. Leiterbahnenden (Anschlusselemente) 60, 61 des Leistungshalbleitermoduls sind wie Figur 7 zeigt wie vorbeschrieben durchsteckbar zur Durchkontaktierung (sog. "Through Hole Process") ausgebildet und sind direkt in die Leiterplatte eingesteckt.

Leiterbahnenden (Anschlusselemente) 65, 66 sind zur SMT-Verbindung (z.B. Lötung) ausgebildet. Diese Leiterbahnenden 65, 66 sind wie Figur 8 zeigt, nach außen auf die Montageseite 44 des Gehäuses 30 gebogene Lötlaschen.

Diese sind mit entsprechenden Kontaktstellen auf der Leiterplatte an Lötstellen 68 verlötet. Es können auch Leiterbahnenden direkt an den Busbar 51 angelötet oder angeschweißt sein.

### Bezugszeichenliste

- 1: Substrat
- 2: Substratoberseite
- 3: Oberseitenmetallisierung
- 5, 6, 7, 8: Leiterbahnen
- 6a, 7a, 8a: freie Leiterbahnenden
- 9: Anschlusskontaktfläche
- 10: Bonddraht
- 12, 13: Halbleiterbauelemente
- 15: Unterseite
- 17: Randbereich
- 20, 21, 22: Anschlusselemente
- 30: Gehäuse
- 40, 41, 42: Leiterbahnenden
- 40', 41', 42': Leiterbahnenden
- 40", 41", 42": Leiterbahnenden
- 44: Montageseite
- 50: Leiterplatte
- 51: Leiter (Busbar)
- 52: Kühlkörper
- 60, 61, 65, 66: Leiterbahnenden
- 68: Lötstellen

## Patentansprüche

1. Leistungshalbleitermodul
mit einem Substrat (1), auf dem durch Strukturierung einer elektrisch leitenden, auf einer Substratseite (2) aufgebrachten Beschichtung (3) Leiterbahnen (5, 6, 7, 8) ausgebildet sind, wobei
die Leiterbahnen (5, 6, 7, 8) als integrale Leiterbahnbestandteile freie, von der Substratseite (2) gelöste Leiterbahnenden (6a, 7a, 8a) aufweisen, die sich als externe Anschlüsse von dem Substrat (1) wegerstrecken, wobei
das Substrat (1) von einem Gehäuse (30) bedeckt ist, **dadurch gekennzeichnet, dass** sich die freien Leiterbahnenden (6a, 7a, 8a) durch das Gehäuse (30) hindurch nach außen erstrecken, und
die freien Leiterbahnenden (6a, 7a, 8a) eine Führung durch das Gehäuse (30) aufweisen und außerhalb des Gehäuses (30) in einem variablen Winkel zu einer Montageseite (44) des Gehäuses (30) geformt sind.

2. Leistungshalbleitermodul nach Anspruch 1, wobei die Leiterbahnenden (40', 41', 42') unter Bildung von SMT-Kontakten auf der Montageseite (44) des Gehäuses (30) anliegen.

3. Leistungshalbleitermodul nach Anspruch 1, wobei die Leiterbahnenden als Einsteckelemente (40, 41, 42) ausgeformt sind.

## Claims

1. Power semiconductor module
comprising a substrate (1), on which conductor tracks (5, 6, 7, 8) are formed by the structuring of an electrically conductive coating (3) applied on a substrate side (2), wherein
the conductor tracks (5, 6, 7, 8) have, as integral conductor track constituent parts, free conductor track ends (6a, 7a, 8a) which are detached from the substrate side (2) and which extend away from the substrate (1) as external connections, wherein
the substrate (1) is covered by a housing (30), **characterized in that** the free conductor track ends (6a, 7a, 8a) extend through the housing (30) towards the outside, and
the free conductor track ends (6a, 7a, 8a) have a guide through the housing (30) and, outside the housing (30), are shaped at a variable angle with respect to a mounting side (44) of the housing (30).

2. Power semiconductor module according to Claim 1, wherein the conductor track ends (40', 41', 42') bear on the mounting side (44) of the housing (30) with the formation of SMT contacts.

3. Power semiconductor module according to Claim 1, wherein the conductor track ends are shaped as plug-in elements (40, 41, 42).

## Revendications

1. Module de puissance à semiconducteur :
comprenant un substrat (1) sur lequel sont formées des pistes (5, 6, 7, 8) conductrices par structuration d'un revêtement (3) conducteur de l'électricité et déposé sur une face (2) du substrat, dans lequel
les pistes (5, 6, 7, 8) conductrices comportent comme parties intégrantes constitutives de pistes conductrices des extrémités (6a, 7a, 8a) libres de pistes conductrices séparées de la face (2) du substrat et s'éloignant du substrat (1) sous la forme de bornes extérieures, dans lequel
le substrat (1) est recouvert d'un boîtier (30), **caractérisé en ce que** les extrémités (6a, 7a, 8a) libres de pistes conductrices s'étendent à l'extérieur en traversant le boîtier (30), et
les extrémités (6a, 7a, 8a) libres de pistes conductrices comportent un guidage à travers le boîtier (30) et sont conformées à l'extérieur du boîtier (30) sous un angle variable par rapport à la face (44) de montage du boîtier (30).

2. Module de puissance à semiconducteur suivant la revendication 1, dans lequel les extrémités (40', 41', 42') de pistes conductrices s'appliquent à la face (44) de montage du boîtier (30) en formant des contacts SMT.

3. Module de puissance à semiconducteur suivant la revendication 1, dans lequel les extrémités de pistes conductrices sont sous la forme d'éléments (40, 41, 42) à enfichage.
